# EUROPEAN PATENT SPECIFICATION

(11) **EP 1 927 576 B1**
(45) Date of publication and mention of the grant of the patent: **05.01.2011**
(21) Application number: 06301197.7
(22) Date of filing: 30.11.2006
(51) Int. Cl.: B81C 1/00

(54) **Method for making microfluidic devices and devices resulting**
Verfahren zur Herstellung von mikrofluidischen Vorrichtungen und auf diese Weise hergestellte Vorrichtungen
Procédé de fabrication de dispositifs microfluidiques et dispositifs résultants

(43) Date of publication of application: 04.06.2008
(73) Proprietor: Corning Incorporated, Corning NY 14831 (US)
(72) Inventor: Ronan, Tanguy, 77880, GREZ SUR LOING (FR)
(74) Representative: Le Roux, Martine

(56) References cited:
- US-A- 5 376 252
- US-A1- 2003 192 587

## Description

### BACKGROUND

The present invention relates generally to microfluidic devices useful for chemical processing, and particularly to microfluidic devices formed of structured consolidated frit defining recesses or passages in a volume between two or more substrates.

Microfluidic devices as herein understood are generally devices containing fluidic passages or chambers having typically at least one and generally more dimensions in the sub-millimeter to one millimeter range. Microfluidic devices can be useful to perform difficult, dangerous, or even otherwise impossible chemical reactions and processes in a safe, efficient, and environmentally-friendly way.

Microfluidic devices formed of structured consolidated frit defining recesses or passages in a volume between two or more substrates have been developed in previous work by associates of the present inventor(s), as disclosed for example in U.S. Patent No. 6,769,444, "Microfluidic Device and Manufacture Thereof" and related patents or patent publications. Methods disclosed therein include various steps including providing a first substrate, providing a second substrate, forming a first frit structure on a facing surface of said first substrate, forming a second frit structure on a facing surface of said second substrate, and consolidating said first substrate and said second substrate and said first and second frit structures together, with facing surfaces toward each other, so as to form a consolidated-frit-defined recess between said first and second substrates. While the methods of manufacture thus disclosed have been useful to produce devices of the type disclosed therein, it has become desirable to increase the efficiency, in particular the yield, of the processes by which such devices are produced.

### SUMMARY OF THE INVENTION

One aspect of the invention is a method of making a microfluidic device by providing first and second substrates and forming a first frit structure on the first substrate and a second frit structure on the second substrate and consolidating the first and second substrates together, with frit structures facing, so as to form a consolidated-frit-defined and consolidated-frit-surrounded recess between said first and second substrates, where the second substrate has at least one pre-formed through-hole therein, and where forming a second frit structure includes forming a frit layer within said through-hole covering the interior surface of the through-hole to a thickness sufficiently thin to produce, on consolidating the substrates and the first and second frit structures together, a through-hole having an interior surface of consolidated frit continuous with the consolidated frit surrounding the recess.

Another aspect of the invention relates to a microfluidic device including a consolidated frit, a first substrate, and a second substrate; the consolidated frit, the first substrate, and the second substrate being attached together via the consolidated frit, the consolidated frit surrounding at least a first recess between the first and second substrates, the first recess being in fluid communication with a through-hole extending through said second substrate, and wherein the through-hole is lined with consolidated frit continuous with the consolidated frit surrounding the recess, providing a single material interface at the interior of the device.

Additional features and advantages of the invention will be set forth in the detailed description which follows, and in part will be readily apparent to those skilled in the art from that description or recognized by practicing the invention as described herein, including the detailed description which follows, the claims, as well as the appended drawings.

It is to be understood that both the foregoing general description and the following detailed description present embodiments of the invention, and are intended to provide an overview or framework for understanding the nature and character of the invention as it is claimed. The accompanying drawings are included to provide a further understanding of the invention, and are incorporated into and constitute a part of this specification. The drawings illustrate various embodiments of the invention and, together with the description, serve to explain the principles and operations of the invention.

### BRIEF DESCRIPTION OF THE DRAWINGS

Figures 1A-1E are cross-sectional views of substrates processed according to an embodiment of a method of the present invention to form an embodiment of a device of the present invention.

Figure 2 is a cross-sectional view of another embodiment of a device of the present - invention that may be produced by an embodiment of the method of the present invention.

Figures 3A-3C are cross-sectional views of substrates processed according to one aspect of an embodiment of the method of the present invention.

Figures 4A and 4B are cross-sectional views of substrates processed according to another aspect of an embodiment of the method of the present invention.

Figure 5 is a cross-sectional view of a portion of another embodiment of a device of the present invention that may be produced by the aspect of the method represented in Figures 3A-3C and/or 4A-4B.

Figures 6A-6E are cross-sectional views of substrates processed according to another two aspects of an embodiment of the method of the present invention.

Figures 7A-7C are cross-sectional views of substrates processed according to yet another aspect of an embodiment of the method of the present invention.

Figure 8 is a cross-sectional view showing before- and after-consolidating profiles of a sufficiently thin frit layer in an exterior substrate through-hole.

Figure 9 is a cross-sectional view showing before- and after-consolidating profiles of a slightly too thick frit layer in an exterior substrate through-hole.

Figure 10 is a cross-section view illustrating before- and after-consolidating profiles of a significantly too thick frit layer in an exterior substrate through-hole.

Figure 11 is a cross-sectional view showing before- and after-consolidating profiles of a sufficiently thin frit layer in an interior substrate through-hole.

Figure 12 is a cross-sectional view showing before- and after-consolidating profiles of a slightly too thick frit layer in an interior substrate through-hole.

Figure 13 is a cross-section view illustrating before- and after-consolidating profiles of a significantly too thick frit layer in an interior substrate through-hole.

Figure 14 is a grayscale digital photograph of a microfluidic device substrate through-hole produced according to an embodiment of a method of the present invention prior to final or full consolidating.

Figure 15 is a grayscale digital photograph of the microfluidic device substrate through-hole of Figure 14 after final or full consolidating.

### DETAILED DESCRIPTION OF THE PREFERRED EMBODIMENTS

Reference will now be made in detail to the present preferred embodiments of the invention, instances of which are illustrated in the accompanying drawings. Whenever possible, the same reference numerals will be used throughout the drawings to refer to the same or like parts.

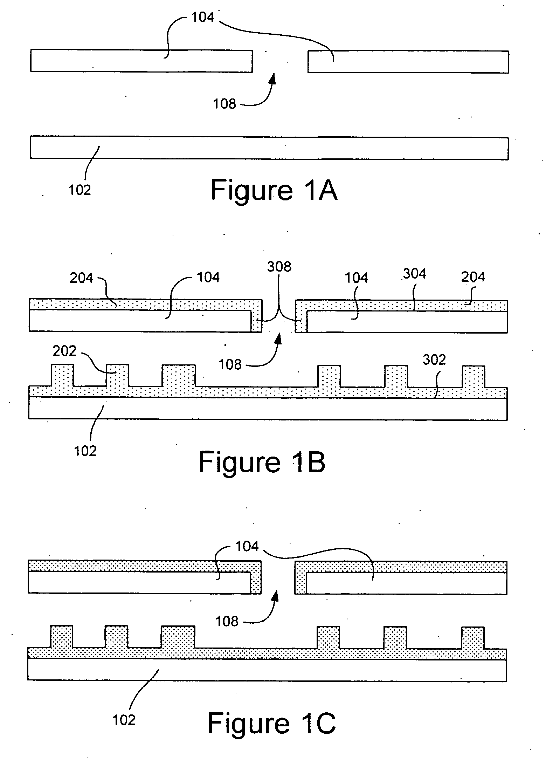

Figures 1A-1E are cross-sectional views of substrates 102 and 104 processed according to an embodiment of a method of the present invention to form an embodiment of a device of the present invention.

The present invention involves the forming and processing of bound frit, meaning frit that is cohered together in some manner prior after a forming process, such as by an organic or other binder or any other suitable means. The present invention also involves consolidated frit or the consolidation of frit, meaning the final densification and solidification of a frit material, such as by sintering or any other suitable means. Partially consolidating the frit means processing the frit so as to move it only partially toward the final consolidated state.

Figure 1A shows first and second bare substrates 102 and 104. The first and second substrates 102 and 104 are desirably planar. They may be of various suitable materials, such as glass, glass-ceramic, and ceramic materials. Lower CTE and higher thermal conductivity are generally desired, as is reasonably good compatibility with frit material and frit consolidating processes. Transparency is also desirable for inspection, sensing, and monitoring flexibility. In the particular cross-section of the figure, there is one through-hole 108 extending through the second substrate 104.

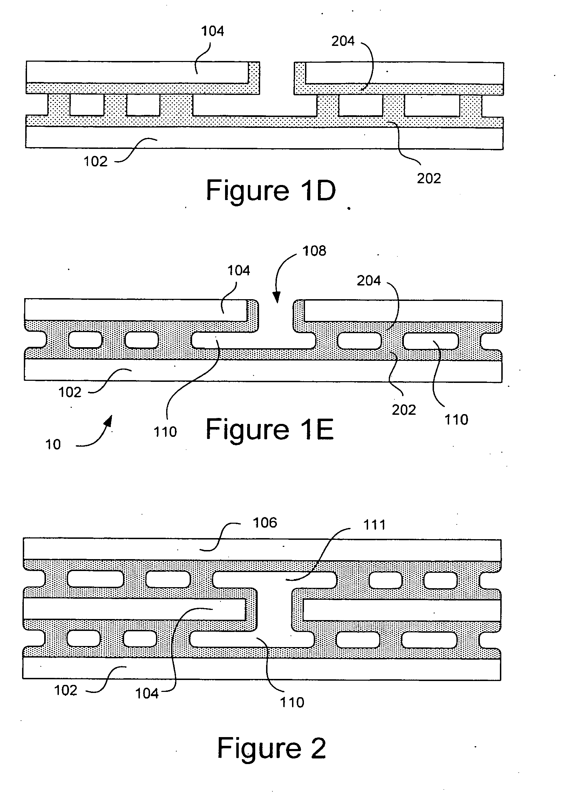

Figure 1B shows first and second substrates 102 and 104 after bound frit structures 202 and 204 have been formed thereon, such as by a molding process. The bound frit structures have been formed on the upper surfaces 302 and 304 of the substrates 102 and 104 as oriented in the figure, but the orientation may be varied during forming or related processing as desired. The surfaces 302 and 304 may be referred to as the facing surfaces of the substrates 102 and 104, as the surfaces 302 and 304 will face each other in the final form of the resulting device. The frit structure 204 of the embodiment of Figure 1 includes a layer 308 of frit positioned on the inside surface of the through-hole 108.

Figure 1C shows the frit structures 202 and 204 on substrates 102 and 104 after a debinding or partial debinding or a partial consolidation of the frit.

Figure 1D shows the debinded or partially debinded or partially consolidated frit structures 202 and 204 stacked in contact with each other for final consolidating, such as by sintering. Debinding or partial debinding or other partial consolidation can under proper conditions improve the strength and cohesiveness of the frit structures. Alternatively, however, as-formed (non-debinded or non-partially consolidated) frit structures may be stacked together and debinded and/or consolidated in one process or in successive processes.

Figure 1E shows the substrates 102 and 104 and the frit structures 202 and 204 after final consolidating such as by sintering. Frit structures 202 and 204 are consolidated to substrates 102 and 104 and to each other so as to form at one or more consolidated-frit-defined recesses 110 between first and second substrates 102 and 104. The resulting microfluidic device 10 includes a consolidated frit 202, 204 and a first substrate 102 and a second substrate 104 all attached together via the consolidated frit 202, 204. At least one recess 110 between the first and second substrates 102 and 104, defined by the consolidated frit 202, 204, is in fluid communication with the through-hole 108 extending through the second substrate 104, and the portion of the consolidated frit 202, 204 resulting from layer 308 is positioned such that the interior surfaces of the relevant first recess 110 and of through-hole 108 are formed of consolidated frit, and such that the consolidated frit lining the through-hole 108 is continuous with the consolidated frit lining the recess 110.

Figure 2 is a cross-sectional view of another embodiment of a device of the present invention that may be produced by an embodiment of a method of the present invention. In particular, Figure 2 illustrates that more than two substrates may be used. In the microfluidic device 10 in the figure, three substrates 102, 104, and 106 are present, and the resulting consolidated frit defines one recess 110 between the first and second substrates 102, 104 and a second recess 111 between the second and third substrates 104, 106. The first recess 110 and the second recess 111 are in fluid communication via the through-hole 108, and the portion of the consolidated frit resulting from a layer corresponding to layer 308 is positioned such that the interior surfaces of the first recess 110, the second recess 111, and through hole 108 are all formed of a continuous consolidated frit. The structures resulting from the methods of the present invention may extend to several substrates in parallel.

According to the methods of the present invention, providing substrates that include through-holes significantly improves the manufacturing yield and associated cost of producing microfluidic devices of the present type. By providing substrates with holes already present, one of the most significant risks of breakage, that produced by hold drilling, is moved to just prior to or at the first step of the process. Investment in the frit forming processes on a given substrate are thus not at risk of loss by substrate breakage during hole drilling. Further, a potential source of contamination or non-uniformities and inclusions is removed, relative to the prior process, in that no drilling chips or shards are produced in the presence of green or debinded but unconsolidated frit structures.

Still further, the inventive process or method also allows for the production of consolidated-frit-lined through-holes, both at the exterior as in Figure 1E and within the device as in Figure 2. This allows for the production of a microfluidic device comprising two or more substrates or floors of materials selected from glass, ceramic, or glass-ceramic, or even other materials, with the substrates or floors spaced apart and attached together by a consolidated glass or glass-ceramic frit between successive substrates or floors, and with the frit forming walls defining passages within said device as well as forming a coating such that interior surfaces of the device are entirely lined with consolidated frit. Thus materials and properties of the substrate and the frit can be selected independently to some degree, to produce devices having higher performance than devices with all similar materials. For instance, one or more substrates may be selected for highest thermal conductivity, while a frit may be optimized for chemical durability, in general, or under particular reaction conditions.

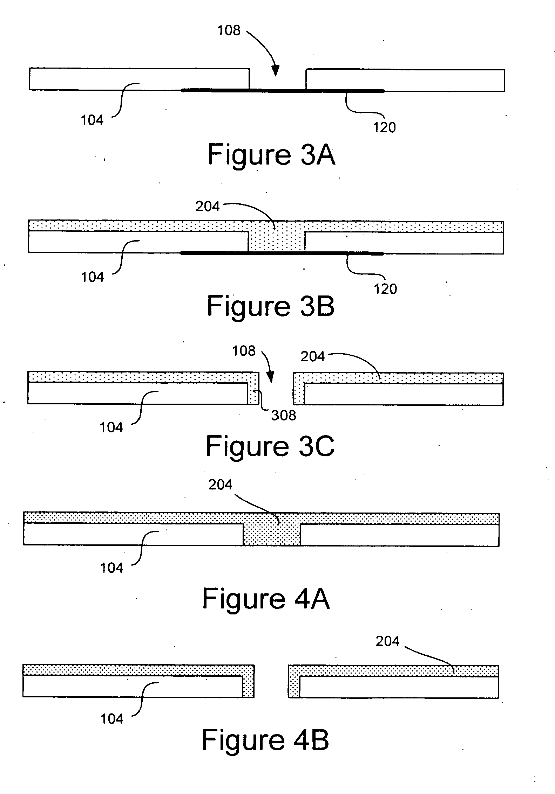

The layer 308 lining the one or more through-holes 108 may be produced in various ways. For instance, as shown in Figures 3A and 3B, a through-hole 108 may be filled with a bound frit to form a frit structure 204. An adhesive film or other backing material 120 may be used to contain the frit on the reverse side of the substrate 104 during filling of the through-hole 108. After forming, if the as-formed bound frit has sufficient strength, the resulting filled hole may be drilled through, resulting in a substrate 104 with a frit structure 204 thereon, where the frit structure includes a layer 308 lining a through-hole 108 in the substrate 104, as shown in Figure 3C. Alternatively, if the as-formed frit is insufficiently strong, the frit may be debinded or partially debinded, or otherwise partially consolidated, resulting in a partially or fully debinded or partially consolidated frit structure 204 as shown in Figure 4A, which may then be drilled through, resulting in the structure of Figure 4B. Reopening frit-filled holes, whether filled with as-formed frit or debinded or partially debinded or partially consolidated frit, is relatively easy and can typically be done with a high speed steel bit, generally without any liquid cooling, in strong contrast to drilling directly in glass or ceramic substrates.

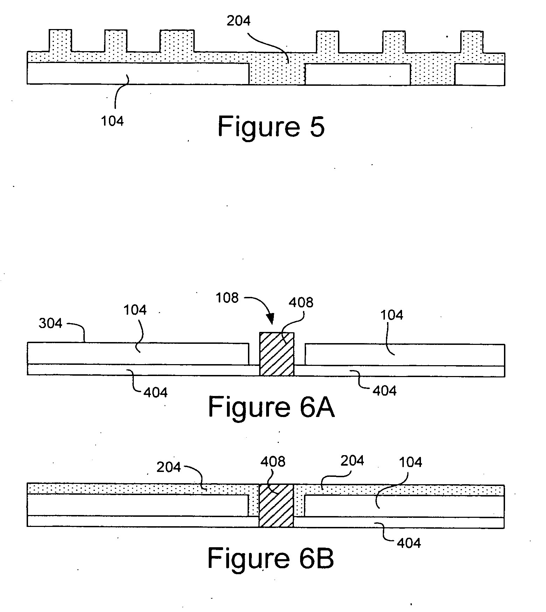

Multiple through holes may be desirable in a given substrate, and the frit structure with which through-holes are initially filled need not be a simple or planar frit structure. Structures such as that shown in Figure 5 may be desirable, for instance.

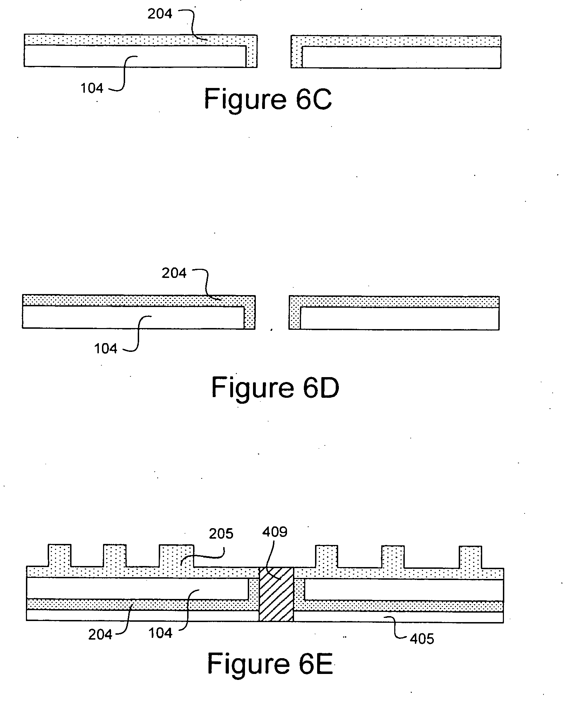

Other ways to produce the layer 308 lining the one or more through-holes 108 are shown in relation to Figures 6A-6E. Figure 6A shows a substrate 104 placed in contact with a pin positioning plate or layer 404. The pin positioning plate or layer 404 holds a passage-maintaining structure in the form of a pin 408, and is positioned relative to the substrate 104 such that the pin 408 is located at or near the center of the hole 108 in the substrate 104, as shown in Figure 6A. The pin may also advantageously protrude above the facing surface 304 by about the intended minimum thickness of the frit structure to come. A frit structure 204 is then formed on the substrate 104 and into the remaining open portions of the hole 108, such as by molding a frit and binder mixture onto the substrate 104, as shown in Figure 6B. Removal of the pin positioning plate or layer 404 with its accompanying pin 408 then leaves the structure shown in Figure 6C, which may then be debinded or partially debinded or partially consolidated resulting in the structured frit material 204 of Figure 6D.

Where frit structure is desired on both sides of the substrate 104, an additional pin positioning plate or layer 405 with an additional pin 409 may be re-inserted such that the pin positioning plate is on the side of the previously formed frit structure 204. This step may be performed with the previous frit structure 204 be in the debinded or partially debinded or partially consolidated state as shown, or even in the as-formed state, depending on the mechanical robustness the structure 204 exhibits in the as-formed state. If structure 204 has a more complex shape than the simple planar shape shown, the additional pin positioning plate or layer 405 may be smaller in lateral extent than that shown in Figure 6E, or even nonplanar, so as to accommodate or conform to the possible complex shape of structure 204.

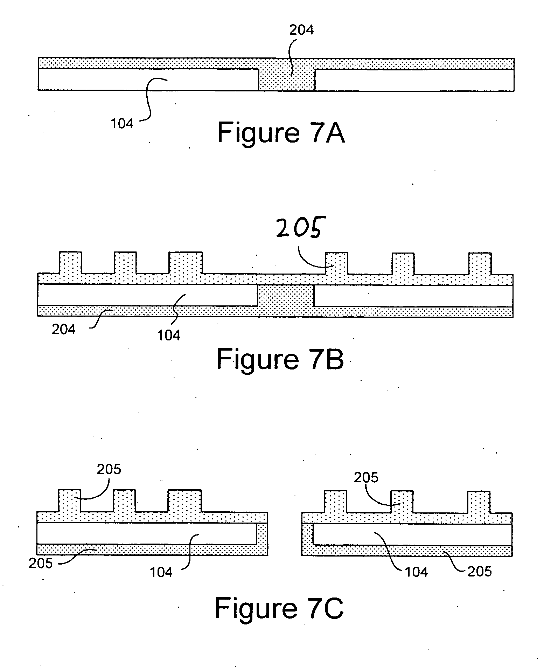

The embodiment of the methods of the present invention relative to Figures 3A-3C or to Figures 4A-4B uses a substrate 104 with a through-hole 108 that is first filled and then drilled out, leaving a layer of frit structure or material on the walls of the original hole. This particular alternative may also be adapted to substrates having a frit structure on both sides. This is shown in brief in Figures 7A-7C. If needed for strength, the frit structure 204 first formed on the substrate 104 may be debinded or partially debinded or partially consolidated as shown in Figure 7A (with the darker denser fill of 204 in the figure representing a debinded or partially debinded or partially consolidated material. A second structured frit 205 may then be formed on the remaining open major surface of the substrate 104 as shown in Figure 7B. The resulting filled hole may then be drilled out while structure 105 is still in the as-formed state, as shown in Figure 7C.

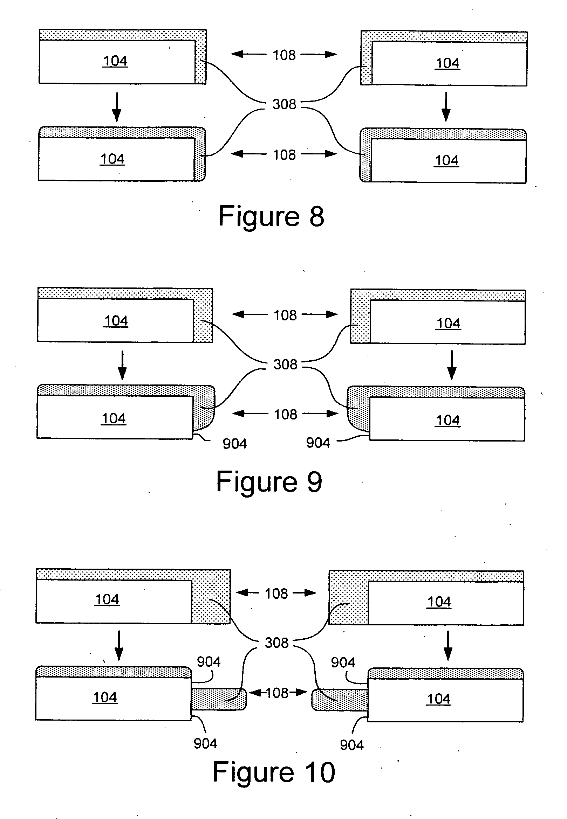

Figures 8-10 illustrate the sensitivity of the inventive process to the thickness of the layer 308 of frit positioned on the inside surface of the through-hole 108, where a frit structure is positioned on only one side of the substrate 104. If the layer 308 is adequately thin, as in Figure 8, the changes in overall shape of the layer resulting from the consolidating process (represented by the descending arrows in the figure) are minimal, and consolidated-frit coverage of the substrate 104 on the inward surfaces of the through-hole 108 is maintained. If the layer 308 is somewhat too thick, the resulting consolidated profile, as shown in Figure 9, can result in exposure of the inner surface 904 of the substrate 104 in the through hole 108, or in other words, can result in a retraction of the frit coating away from the bare major surface of the substrate 104. Where the layer 309 is much too thick, the resulting consolidated profile, shown in Figure 10, exposes the inner surface 904 of the substrate 104 inside the through hole 108 both above and below the layer 308. Thus it is desirable to use an appropriately thin coating of structured frit for the layer 308.

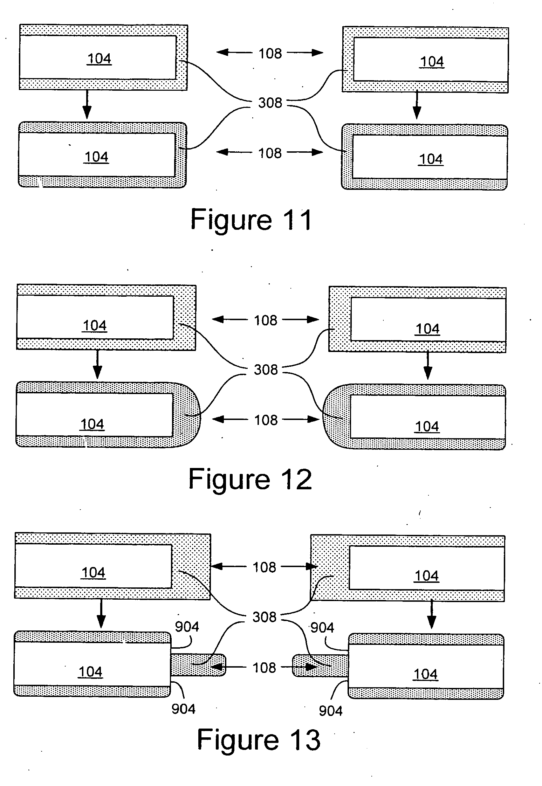

Figures 11-13 illustrate the sensitivity of the inventive process to the thickness of the layer 308 of frit positioned on the inside surface of the through-hole 108, where a frit structure is positioned on both sides of the substrate 104. As may be seen from the profiles in Figures 11 and 12, inner surface of the through-hole 108 is not as readily uncovered during the consolidating process by the use of a thicker layer 308. Nonetheless, thin layers are preferred for best overall dimensional and process control.

The present invention may be desirably utilized with glass, ceramic, and/or glass-ceramic substrates. Metal substrates may also be useful. While CTE mismatch should not be too large between consolidated frit and substrate to preserve resistance to thermal gradients and thermal shock, the present invention finds particular utility in allowing separate optimization of substrate and frit materials, as the present invention allows for a continuous consolidated frit surface on the interior surfaces of microfluidic devices. For many applications, for instance, it may be desirable to choose the substrate material to enhance thermal conductivity over that of the frit, and to choose and/or formulate the frit to provide desired levels of chemical resistance or inertness.

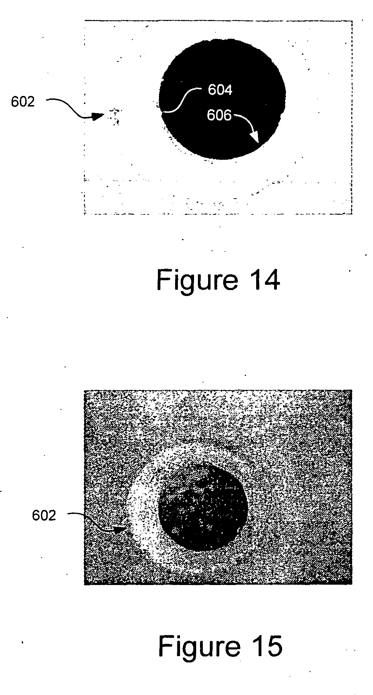

Some additional beneficial effects of the invention can be seen in Figures 14 and 15. Figure 14 is a grayscale digital photograph of a microfluidic device substrate through-hole produced according to an embodiment of a method of the present invention prior to final or full consolidating. Figure 15 is a grayscale digital photograph of the microfluidic device substrate through-hole of Figure 14 after final or full consolidating. Surface defects and roughness can be seen in Figure 14 in the form of a glass chip 602 and in the form of surface bumps 604 and generally sharp corners 606. In Figure 15, it is seen that the glass chip 602 is covered and smoothed over by the consolidated frit, and the surface roughness and sharp edges are also gone. Thus potential mechanical stress concentration points (points likely more susceptible to chemical attack as well) are removed or reduced.

In general, the invention provides a microfluidic device comprising two or more substrates or floors spaced apart and attached together by a consolidated glass or glass-ceramic frit between successive substrates or floors, with the frit forming walls defining passages or chambers within said device and forming a coating such that interior surfaces of the device are entirely lined with consolidated frit. This allows both (1) flexible manufacturing of various device geometries because the passages or chambers (except through-holes) are determined by an additive frit-forming process, and not by a more environmentally-unfriendly and/or more difficult subtractive process, and (2) flexibility in materials optimization because the properties of the frit material can be optimized for contact with fluids while the properties of the substrate can be optimized for strength, thermal conductivity or thermal insulation and the like. Further, use the method of making such devices disclosed herein reduces production cost and increases yield by beginning the production process with substrates having through-holes, thus moving any production losses during drilling or otherwise forming the through holes to the front of the production cycle.

## Claims

1. A method of making a microfluidic device (10), the method comprising:
providing a first substrate (102);
providing a second substrate (104) having at least one through-hole (108) therein;
forming a first frit structure (202) on a facing surface (302) of said first substrate (102);
forming a second frit structure (204) on a facing surface (304) of said second substrate (104); and
consolidating said first substrate (102) and said second substrate (104) and said first and second frit structures (202, 204) together, with facing surfaces (302, 304) toward each other, so as to form a consolidated-frit-surrounded recess (110) between said first and second substrates (102, 104),
the method being **characterized in that**:
forming a second frit structure (204) includes forming a frit layer (308) within said second substrate through-hole (108), said frit layer (308) within said through-hole (108) covering the interior surface of said through-hole (108) to a thickness sufficiently thin to produce, on consolidating said first substrate (102) and said second substrate (104) and
said first and second frit structures (202, 204) together, a through-hole (108) having an interior surface of consolidated frit (308) continuous with the consolidated frit (202, 204) surrounding said recess (110).

2. The method according to claim 1 wherein forming a frit layer (308) within said second substrate through-hole (108) comprises filling said through-hole (108) with a bound frit and drilling through the resulting filled hole.

3. The method according to claim 1 wherein forming a frit layer (308) within said second substrate through-hole (108) comprises filling said through-hole (108) with a bound frit, de-binding said frit, and then drilling through the resulting filled hole.

4. The method according to claim 1 wherein forming a frit layer (308) within said second substrate through-hole (108) comprises positioning a passage-maintaining structure (408 ; 409) within the through-hole (108), and filling the remaining volume of the hole not occupied by the passage-maintaining structure (408 ; 409) with a bound frit, and removing the passage-maintaining structure (408 ; 409).

5. The method according to any of claims 1-4 wherein providing a first substrate (102) comprises providing a glass, ceramic, or glass-ceramic substrate.

6. The method according to any of claims 1-5 wherein said material of which first substrate (102) or said second substrate (204) is formed is selected from a material having a higher coefficient of thermal conductivity than said frit (202, 204).

7. The method according to any of claims 1-6 wherein said consolidated frit (202, 204) is selected so as to have a greater degree of resistance to chemical attack than a material of said of which either said first substrate (102) or said second substrate (104) is formed.

8. A microfluidic device (10) comprising: a consolidated frit (202 + 204); a first substrate (102); and a second substrate (104); the consolidated frit (202 + 204), the first substrate (102), and the second substrate (104) being attached together via the consolidated frit (202 + 204), the consolidated frit (202 +204) surrounding at least a first recess (110) between the first and second substrates (102, 104), said first recess (110) being in fluid communication with a through-hole (108) extending through said second substrate (104),
the microfluidic device (10) being **characterized in that** said through-hole (108) is lined with consolidated frit (308) continuous with the consolidated frit (202 + 204) surrounding the recess (110).

9. The microfluidic device (10) of claim 8 wherein it further comprises a third substrate (106) attached via the consolidated frit (202 + 204) to the first and second substrates (102, 104), the consolidated frit (202 + 204) surrounding at least a second recess (111) between the second and third substrates (104, 106), the first recess (110) being in communication with the second recess (111) via the through-hole (108), the through-hole (108) being lined with consolidated frit (308) continuous with the consolidated frit (202 + 204) surrounding said first and second recesses (110, 111).

10. The microfluidic device (10) of either of claims 8 and 9 wherein a material of which one or more of the substrates (102, 104, 106) is formed has a higher thermal conductivity than the consolidated frit (202 + 204).

## Patentansprüche

1. Verfahren zur Herstellung einer mikrofluidischen Vorrichtung (10), wobei das Verfahren umfaßt:
Bereitstellen eines ersten Substrates (102),
Bereitstellen eines zweiten Substrates (104), das wenigstens eine durchgehende Öffnung (108) aufweist,
Ausbilden einer ersten Frittenstruktur (202) auf einer Oberfläche (302) des ersten Substrates (102),
Ausbilden einer zweiten Frittenstruktur (204) auf einer Oberfläche (304) des zweiten Substates (104) und
miteinander Festigen des ersten Substrates (102) und des zweiten Substrates (104) und der ersten und zweiten Frittenstruktur (202, 204) mit zugewandten Flächen (302, 304), um eine verfestigte frittenumgebende Aushöhlung (110) zwischen dem ersten und dem zweiten Substrat (102, 104) auszubilden,
wobei das Verfahren **dadurch gekennzeichnet ist, daß** das
Ausbilden einer zweiten Frittenstruktur (204) das Ausbilden einer Frittenschicht (308) in der durchgehenden Öffnung (108) des zweiten Substrates umfaßt, wobei die Frittenschicht (308) in der durchgehenden Öffnung (108) die innere Fläche der durchgehenden Öffnung (108) in einer Dicke belegt, die gerade stark genug ist, bei der Verfestigung des ersten Substrates (102) und des zweiten Substrates (104) und der ersten und zweiten Frittenstrukturen (202, 204) miteinander eine durchgehende Öffnung (108) mit einer inneren Fläche aus verfestigter Fritte (308) auszubilden, die mit der verfestigten, die Aushöhlung (110) umgebenden Fritte (202, 204) durchgängig ist.

2. Verfahren nach Anspruch 1, wobei das Ausbilden der Frittenschicht (308) in der durchgehenden Öffnung (108) des zweiten Substrates das Füllen der durchgehenden Öffnung (108) mit einer gebundenen Fritte und das Durchbohren der resultierenden gefüllten Öffnung umfaßt.

3. Verfahren nach Anspruch 1, wobei das Ausbilden der Frittenschicht (308) in der durchgehenden Öffnung (108) des zweiten Substrates das Füllen der durchgehenden Öffnung (108) mit einer gebundenen Fritte, das Entbinden der Fritte und das anschließende Durchbohren der resultierenden gefüllten Öffnung umfaßt.

4. Verfahren nach Anspruch 1, wobei das Ausbilden der Frittenschicht (308) in der durchgehenden Öffnung (108) des zweiten Substrates das Positionieren einer durchgangserhaltenden Struktur (408, 409) in der durchgehenden Öffnung (108) und das Füllen des übrigen, durch die durchgangerhaltende Struktur (408, 409) nicht belegten Volumens der Öffnung mit einer gebundenen Fritte und das Entfernen der durchgangserhaltenden Struktur (408, 409) umfaßt.

5. Verfahren nach einem der Ansprüche 1 - 4, wobei das Bereitstellen eines ersten Substrates (102) das Bereitstellen eines Glas-, Keramik- oder Glas-Keramik-Substrates umfaßt.

6. Verfahren nach einem der Ansprüche 1 - 5, wobei das Material, aus welchem das erste Substrat (102) oder das zweite Substrat (204) ausgebildet ist, aus einem Material mit einer höheren Wärmeleitzahl als die der Fritte (202, 204) ausgewählt ist.

7. Verfahren nach einem der Ansprüche 1 - 6, wobei die verfestigte Fritte (202, 204) so ausgewählt ist, daß sie eine höhere Widerstandfähigkeit gegen chemische Angriffe als das Material, aus welchem entweder das erste Substrat (102) oder das zweite Substrat (104) ausgebildet ist, zu besitzen.

8. Mikrofluidische Vorrichtung (10), umfassend: eine verfestigte Fritte (202 + 204), ein erstes Substrat (102) und ein zweites Substrat (104), wobei die verfestigte Fritte (202 + 204), das erste Substrat (102) und das zweite Substrat (104) miteinander über die verfestigte Fritte (202 + 204) verbunden sind, die verfestigte Fritte (202 + 204) wenigstens eine erste Aushöhlung (110) zwischen dem ersten und zweiten Substrat (102, 104) umgibt und die erste Aushöhlung (110) in Fluidkommunikation mit einer durchgehenden Öffnung (108), die sich durch das zweite Substrat (104) erstreckt, ist, wobei die mikrofluidische Vorrichtung (10) **dadurch gekennzeichnet ist, daß** die durchgehende Öffnung (108) mit verfestigter Fritte (308) beschichtet ist, die mit der verfestigten, die Aushöhlung (110) umgebenden Fritte (202 + 204) durchgehend ist.

9. Mikrofluidische Vorrichtung (10) nach Anspruch 8, ferner umfassend ein drittes, mit dem ersten und zweiten Substrat (102, 104) über die verfestigte Fritte (202 + 204) verbundenes Substrat (106), wobei die verfestigte Fritte (202 + 204) wenigstens eine zweite Aushöhlung (111) zwischen dem zweiten und dritten Substrat (104, 106) umgibt, die erste Aushöhlung (110) über die durchgehende Öffnung (108) in Verbindung mit der zweiten Aushöhlung (111) steht und die durchgehende Öffnung (108) mit der verfestigten Fritte (308) beschichtet ist, die mit der verfestigten, die erste und zweite Aushöhlung (110, 111) umgebenen Fritte (202 + 204) durchgängig ist.

10. Mikrofluidische Vorrichtung (10) nach Anspruch 8 oder 9, wobei ein Material aus welchem eines oder mehrere der Substrate (102, 104, 106) ausgebildet sind, eine höhere Wärmeleitzahl als die der verfestigten Fritte (202 + 204) besitzt.

## Revendications

1. Procédé de fabrication d'un dispositif microfluidique (10), le procédé comprenant :
la fourniture d'un premier substrat (102) ;
la fourniture d'un deuxième substrat (104) ayant au moins un trou de passage (108) en lui ;
la formation d'une première structure frittée (202) sur une surface de dessus (302) dudit premier substrat (102) ;
la formation d'une deuxième structure frittée (204) sur une surface de dessus (304) dudit deuxième substrat (104) ; et
la consolidation dudit premier substrat (102) et dudit deuxième substrat (104) et desdites première et deuxième structures frittées (202, 204) ensemble, les surfaces de dessus (302, 304) étant dirigées les unes vers les autres, de façon à former un renfoncement entouré de fritte consolidée (110) entre lesdits premier et deuxième substrats (102, 104),
le procédé étant **caractérisé en ce que** :
la formation d'une deuxième structure frittée (204) comprend la formation d'une couche frittée (308) à l'intérieur dudit trou de passage (108) du deuxième substrat, ladite couche frittée (308) à l'intérieur dudit trou de passage (108) recouvrant la surface intérieure dudit trou de passage (108) d'une épaisseur suffisamment mince pour produire, lors de la consolidation dudit premier substrat (102) et dudit deuxième substrat (104) et desdites première et deuxième structures frittées (202, 204) ensemble, un trou de passage (108) ayant une surface intérieure de fritte consolidée (308) continue avec la fritte consolidée (202, 204) entourant ledit renfoncement (110).

2. Procédé selon la revendication 1, dans lequel la formation d'une couche frittée (308) à l'intérieur dudit trou de passage du deuxième substrat (108) comprend le remplissage dudit trou de passage (108) avec une fritte liée et le percement au travers du trou rempli ainsi obtenu.

3. Procédé selon la revendication 1, dans lequel la formation d'une couche frittée (308) à l'intérieur dudit trou de passage du deuxième substrat (108) comprend le remplissage dudit trou de passage (108) avec une fritte liée, le déliantage de ladite fritte et le perçage ensuite au travers du trou rempli ainsi obtenu.

4. Procédé selon la revendication 1, dans lequel la formation d'une couche frittée (308) à l'intérieur dudit trou de passage du deuxième substrat (108) comprend le positionnement d'une structure de maintien de passage (408 ; 409) à l'intérieur du trou de passage (108) et le remplissage du volume restant du trou non occupé par la structure de maintien de passage (408 ; 409) avec une fritte liée et le retrait de la structure de maintien de passage (408 ; 409).

5. Procédé selon l'une quelconque des revendications 1 à 4, dans lequel la fourniture d'un premier substrat (102) comprend la fourniture d'un substrat en verre, en céramique ou en vitrocéramique.

6. Procédé selon l'une quelconque des revendications 1 à 5, dans lequel ledit matériau dans lequel ledit premier substrat (102) ou ledit deuxième substrat (204) est réalisé est sélectionné parmi les matériaux ayant un coefficient de conductivité thermique plus élevé que celui desdites frittes (202, 204).

7. Procédé selon l'une quelconque des revendications 1 à 6, dans lequel ladite fritte consolidée (202, 204) est sélectionnée de façon à avoir un degré de résistance aux attaques chimiques plus élevé que le matériau dans lequel ledit premier substrat (102) ou ledit deuxième substrat (104) est formé.

8. Dispositif microfluidique (10) comprenant :
une fritte consolidée (202 + 204) ; un premier substrat (102) ; et un deuxième substrat (104) ; la fritte consolidée (202 + 204), le premier substrat (102) et le deuxième substrat (104) étant solidarisés ensemble par le biais de la fritte consolidée (202 + 204), la fritte consolidée (202 + 204) entourant au moins un premier renfoncement (110) entre les premier et deuxième substrats (102, 104), ledit premier renfoncement (110) étant en communication de fluide avec un trou de passage (108) qui s'étend au travers dudit deuxième substrat (104),
le dispositif microfluidique (10) étant **caractérisé en ce que** ledit trou de passage (108) est recouvert d'une fritte consolidée (308) continue avec la fritte consolidée (202 + 204) qui entoure le renfoncement (110).

9. Dispositif microfluidique (10) selon la revendication 8, comprenant par ailleurs un troisième substrat (106) fixé aux premier et deuxième substrats (102, 104) par le biais de la fritte consolidée (202 + 204), la fritte consolidée (202 + 204) entourant au moins un second renfoncement (111) entre les deuxième et troisième substrats (104, 106) ; le premier renfoncement (110) étant en communication avec le second renfoncement (111) par le biais du trou de passage (108), le trou de passage (108) étant recouvert d'une fritte consolidée (308) continue avec la fritte consolidée (202 + 204) qui entoure lesdits premier et second renfoncements (110, 111).

10. Dispositif microfluidique (10) selon la revendication 8 ou 9, dans lequel le matériau dans lequel un ou plusieurs des substrats (102, 104, 106) sont formés a un coefficient de conductivité thermique plus élevé que celui de la fritte consolidée (202 + 204).
